(19) Europäisches Patentamt

European Patent Office

Office européen des brevets

(11) **EP 0 632 580 B1**

(12) **EUROPÄISCHE PATENTSCHRIFT**

(45) Veröffentlichungstag und Bekanntmachung des Hinweises auf die Patenterteilung:
**01.03.2000 Patentblatt 2000/09**

(51) Int. Cl.$^7$: **H03F 3/30**

(21) Anmeldenummer: **94108946.8**

(22) Anmeldetag: **10.06.1994**

(54) **Verstärkerausgangsstufe**

Output amplifier stage

Etage de sortie amplificateur

(84) Benannte Vertragsstaaten:
**FR GB IT**

(30) Priorität: **17.06.1993 DE 4320061**

(43) Veröffentlichungstag der Anmeldung:
**04.01.1995 Patentblatt 1995/01**

(73) Patentinhaber:
• **SIEMENS AKTIENGESELLSCHAFT**
**80333 München (DE)**
• **FRAUNHOFER-GESELLSCHAFT ZUR FÖRDERUNG DER ANGEWANDTEN FORSCHUNG E.V.**
**80636 München (DE)**

(72) Erfinder:
• **Maschmann, Martin, Dipl.-Ing.**
**D-47058 Duisburg (DE)**
• **Hosticka, Bedrich, Prof.**
**D-47058 Duisburg (DE)**
• **Schardein, Werner, Dr. rer. nat.**
**D-46047 Oberhausen (DE)**

(74) Vertreter:
**Epping, Wilhelm, Dr.-Ing.**
**Patentanwalt**
**Postfach 22 13 17**
**80503 München (DE)**

(56) Entgegenhaltungen:
**US-A- 3 987 368        US-A- 4 636 744**

• **WIRELESS WORLD, Bd. 89, Nr. 1566, März 1983 OLCHESTER GB, Seiten 69-75, ERNO BORBELY 'HIGH POWER HIGH QUALITY AMPLIFIER USING MOSFETS'**
• **ELECTRONICS LETTERS, Bd. 27, Nr. 12, 6.Juni 1991 STEVENAGE GB, Seiten 10-12, XP 000237756 A. NOSRATINIA ET AL 'HIGH-DRIVE CMOS BUFFER FOR LARGE CAPACITIVE LOADS'**

**Beschreibung**

Die vorliegende Erfindung betrifft eine Verstärkerausgangsstufe.

Insbesondere befaßt sich die vorliegende Erfindung mit einer niederohmigen Ausgangsstufe für einen Verstärker, der mit kleinen Versorgungsspannungen betrieben werden kann und eine Spannungsverstärkung größer als eins ermöglicht.

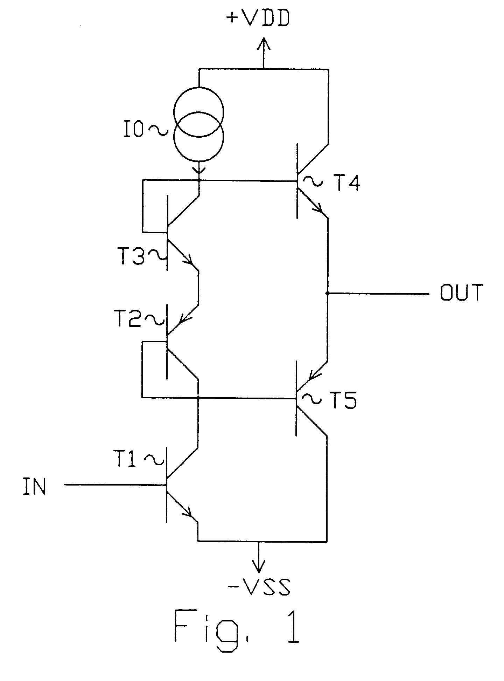

Typischerweise werden zum Treiben von großen kapazitiven und resistiven Lasten bei großen Versorgungsspannungen sogenannte Klasse-AB-Gegentaktendstufen verwendet. Eine derartige Klasse-AB-Gegentaktendstufe hat typischerweise die in Figur 1 gezeigte Schaltungsstruktur mit fünf Transistoren T1 bis T5 und einer Stromquelle I0. Die in Figur 1 gezeigte Ausgangsstufe erreicht maximal einen Ausgangspegel, der bis auf die Summe einer Basis-Emitter-Spannung und einer Kollektor-Emitter-Sättigungsspannung an die positive bzw. negative Versorgungsspannung VDD, VSS heranreicht. Hieraus ergibt sich der typische Einsatzbereich derartiger Klasse-AB-Gegentaktendstufen für Versorgungsspannungen oberhalb von 5 V. Für Versorgungsspannungen von etwa 2 V und darunter ist die Ausgangsstufe gemäß Figur 1 völlig ungeeignet, da die hier mögliche Ausgangsaussteuerung nur noch maximal 100 bis 200 mV vom Mittenpotential aus beträgt.

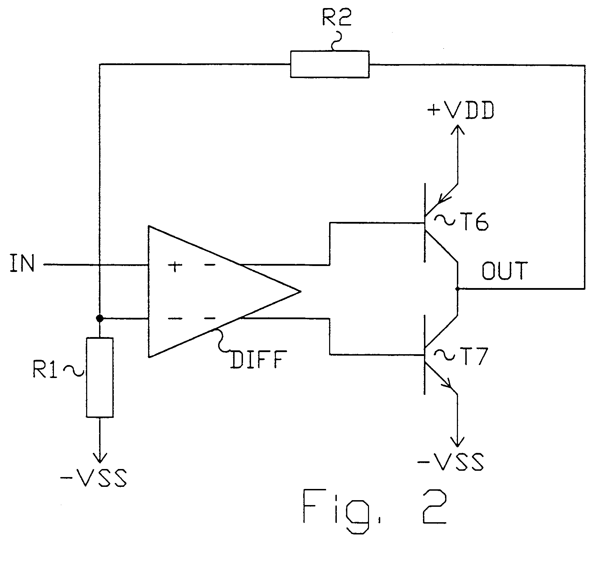

Daher werden bei niedrigen Versorgungsspannungen von etwa 2 V Schaltungsprinzipien eingesetzt, wie sie in Figur 2 gezeigt sind. Ein Differenzverstärker DIFF erzeugt Ansteuerspannungen für zwei ausgangsseitige Bipolartransistoren T6, T7, die in Emitterschaltung betrieben werden. Der Ausgang ist über zwei Widerstände R2, R1 auf den invertierenden Eingang des Differenzverstärkers DIFF rückgekoppelt.

Eine entsprechende Schaltungsstruktur kann auch mit ausgangsseitigen MOS- Transistoren implementiert werden.

Die Ausgangsspannung dieser in Figur 2 gezeigten Ausgangsstufe erreicht die Versorgungspegel VDD, VSS bis auf eine Emitter-Kollektor-Sättigungsspannung, so daß die Ausgangsspannung um eine Basis-Emitter-Spannung höher ist als die Ausgangsspannung der Ausgangsstufe, die in Figur 1 gezeigt ist.

Da die Kollektoren der Ausgangstransistoren T6, T7 den Ausgang dieser Stufe bilden, ist dieser hochohmig. Dies bedeutet, daß bei Spannungsänderungen am Ausgang beispielsweise durch externe Ursachen nur eine minimale Stromänderung durch die Ausgangstransistoren T6, T7 erfolgt. Spannungsänderungen durch externe Ursachen am Ausgang können die Ausgangstransistoren T6, T7 also allein nicht kompensieren, wie es die Transistoren T4 und T5 in Fig. 1 durch die Emittergegenkopplung können. Nur durch die Rückkopplung der Ausgangsspannungen über die Widerstände R2, R1 auf den invertierenden Eingang des Differenzverstärkers DIFF kann sich der Strom durch die Ausgangstransistoren ändern. Bei einer Spannungsänderung am invertierenden Eingang des Differenzverstärkers durch eine Spannungsänderung am Ausgang ändert sich daher die Ansteuerspannung für die Ausgangstransistoren und somit der Strom durch den Ausgang. Die Höhe der Reaktion des Differenzverstärkers auf eine unerwünschte Änderung der Ausgangsspannung hängt vom Teilerfaktor TL ab, der durch die Widerstandswerte der Gegenkopplungswiderstände R1, R2 festgelegt ist. Es gilt: $TL = R1/(R1 + R2))$ . Ferner hängt die Höhe der Reaktion von der Verstärkung des Differenzverstärkers ab. Je größer die Verstärkung ist und je größer der Teilerfaktor TL ist, desto größer ist die Reaktion auf Änderungen der Ausgangsspannung und desto niederohmiger ist die Ausgangsstufe.

Durch die Frequenzabhängigkeit der Verstärkung des Differenzverstärkers DIFF (Abfall der Verstärkung zu hohen Frequenzen hin) nimmt der Ausgangswiderstand der in Figur 2 gezeigten Schaltung mit zunehmenden Frequenzen zu. Durch die bei hohen Frequenzen wachsende Phasenverschiebung des die Ausgangsstufentransistoren T6,T7 ansteuernden Differenzverstärkers DIFF ist die Bandbreite dieser bekannten Ausgangsstufe begrenzt.

Aus der US-Patentschrift 4,636,744 ist eine gattungsgemäße Verstärkerausgangsstufe bekannt.

Ausgehend von diesem Stand der Technik liegt der vorliegenden Erfindung daher die Aufgabe zugrunde, eine Verstärkerausgangsstufe zu schaffen, die mit niedrigen Versorgungsspannungen betrieben werden kann und dennoch eine geringe Frequenzabhängigkeit des Ausgangswiderstandes und hohe Bandbreite hat.

Diese Aufgabe wird durch eine Verstärkerausangsstufe gemäß Patentanspruch 1 gelöst.

Bevorzugte Weiterbildungen der Erfindung sind in den Unteransprüchen angegeben.

Bevorzugte Ausführungsbeispiele der erfindungsgemäßen Verstärkerausgangsstufe werden nachfolgend unter Bezugnahme auf die beiliegenden Zeichnungen näher erläutert. Es zeigen:

Fig. 1    eine bekannte Klasse-AB-Gegentaktendstufe;

Fig. 2    eine bekannte Ausgangsstufe für niedrige Versorgungsspannungspegel;

Fig. 3 bis 7    ein erstes bis fünftes Ausführungsbeispiel der erfindungsgemäßen Verstärkerausgangsstufe; und

Fig. 8    eine Ausführungsform einer Stromversorgungsschaltung für die in den Figuren 6 und 7 gezeigten Ausführungsbeispiele der erfindungsgemäßen Verstärkerausgangsstufe.

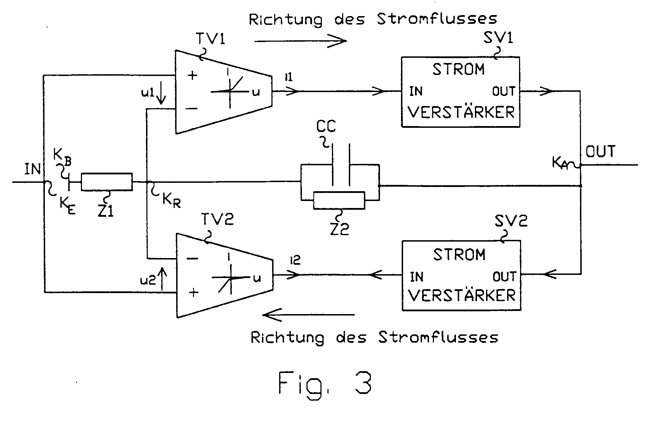

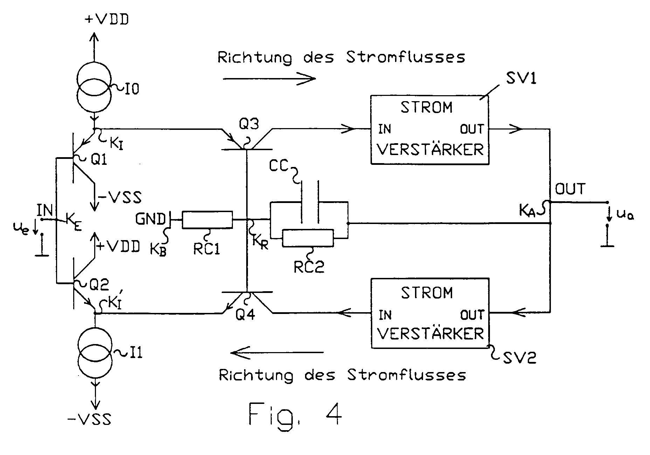

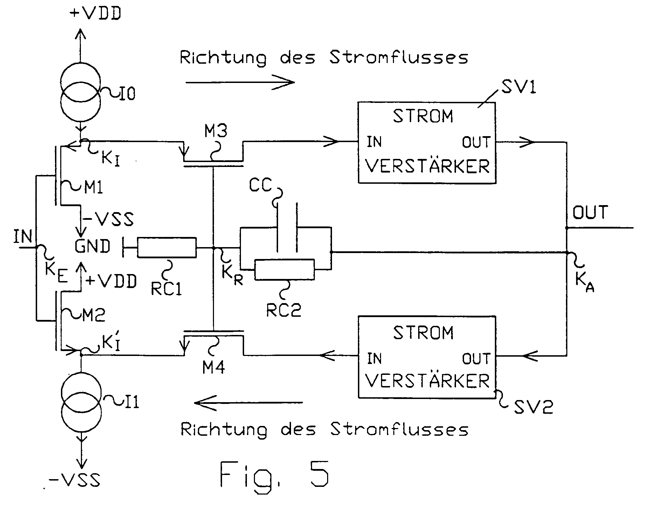

Figur 3 gibt die Grundstruktur der erfindungsgemäßen Verstärkerausgangsstufe wieder. Die dort gezeigte Verstärkerausgangsstufe V umfaßt zwei komplementäre Transkonduktanzverstärker TV1, TV2 mit jeweils zwei Eingängen und einem Ausgang, die jeweils eine asymmetrische Charakteristik ihres Ausgangsstromes von der an ihren Eingängen anliegenden Spannung bei entgegengesetzten Stromflußrichtungen ihrer Ausgangsströme I1, I2 haben. Der Ausgangsstrom I1 des ersten Transkonduktanzverstärkers TV1 wächst mit wachsender positiver Eingangsspannung u1, hat bei der Eingangsspannung u1 mit dem Wert 0 einen positiven Wert und nimmt mit wachsender negativer Eingangsspannung ab, wobei jedoch bei dem hier gezeigten bevorzugten Ausführungsbeispiel innerhalb des Eingangsspannungsbetriebsbereiches der Schaltung auch bei maximal negativer Eingangsspannung u1 ein von 0 verschiedener, positiver Strom in den Ausgang eingeprägt wird. Bei dem zu dem ersten Transkonduktanzverstärker TV1 komplementär ausgeführten zweiten Transkonduktanzverstärker TV2 hat die Charakteristik des Ausgangsstromes I2 bezogen auf die Eingangsspannung U2 einen derartigen Verlauf, daß der Ausgangsstrom I2 des zweiten Transkonduktanzverstärkers TV2 mit wachsender negativer Eingangsspannung wächst, bei der Eingangsspannung mit dem Wert 0 einen negativen Wert hat und mit wachsender positiver Eingangsspannung abnimmt. Auch hier wird jedoch bei maximal positiver Eingangsspannung immer noch ein von 0 verschiedener Ausgangsstrom I2 in den Ausgang eingeprägt.

Ferner umfaßt die Verstärkerausgangsstufe V1 zwei Stromverstärker SV1, SV2, deren Eingänge mit dem Ausgang der beiden Transkonduktanzverstärker TV1, TV2 verbunden sind und deren Ausgänge mit dem Ausgangsknoten $K_A$ der Verstärkerstufe V verbunden sind. Ein Rückkopplungsnetzwerk Z1, Z2, CC ist zwischen dem Ausgangsknoten $K_A$ und einem Bezugspotentialknoten $K_B$ geschaltet, wobei der Bezugspotentialknoten $K_B$ bei dem hier gezeigten Ausführungsbeispiel auf Massepotential liegt. Das Rückkopplungsnetzwerk definiert einen Rückkopplungsknoten $K_R$, der mit den beiden invertierenden Eingängen der Transkonduktanzverstärker TV1, TV2 verbunden ist. Der jeweilige positive bzw. nicht-invertierende Eingang der Transkonduktanzverstärker TV1, TV2 ist mit einem Eingangsknoten $K_E$ der Verstärkerausgangsstufe verbunden, an den das gegen Massepotential definierte Eingangsspannungssignal $U_e$ angelegt werden kann.

Die erfindungsgemäße Verstärkerausgangsstufe V1 deren grundlegende Struktur in Form eines Ausführungsbeispieles in Figur 3 gezeigt ist, ermöglicht es, den Ausgangswiderstand der Verstärkerausgangsstufe niedrig zu halten, ohne die Rückkopplung über den gesamten Verstärker nutzen zu müssen, wie dies bei der Schaltung gemäß Figur 2 der Fall ist. Im Gegensatz zu der Stufe nach Figur 2 wird bei der erfindungsgemäßen Verstärkerausgangsstufe V auf eine Spannungsansteuerung von Ausgangstransistoren verzichtet, so daß eine hohe Bandbreite bei der erfindungsgemäßen Verstärkerausgangsstufe erzielt wird.

Die bei der erfindungsgemäßen Verstärkerausgangsstufe verwendeten Transkonduktanzverstärker TV1, TV2 können sehr einfach ausgeführt werden, da sie keine besonderen Liniaritätsanforderungen erfüllen müssen.

Bei der nachfolgenden Erläuterung weiterer Ausführungsbeispiele der erfindungsgemäßen Verstärkerausgangsstufen werden für übereinstimmende Schaltungskomponenten übereinstimmende Bezugszeichen verwendet. Diese Schaltungskomponenten sind, soweit nichts gegenteiliges ausgeführt wird, in der bereits definierten Art miteinander verschaltet.

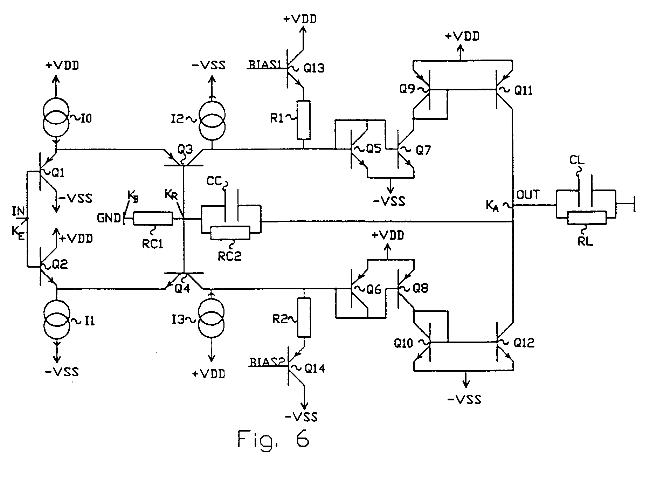

Wie in Figur 4 gezeigt ist, kann jeder der Transkonduktanzverstärker TV1, TV2 durch einen ersten Transistor Q1, Q2, einen zweiten Transistor Q3, Q4 und eine erste Stromquelle I0, I1 gebildet werden. Bei beiden Transkonduktanzverstärkern TV1, TV2 ist jeweils der erste Transistor Q1, Q2 mit seiner Basis mit dem Eingangsknoten $K_E$, mit seinem Kollektor mit dem Versorgungspotential VSS, VDD und mit seinem Emitter mit einem inneren Schaltungsknoten $K_I$, $K_I'$ verbunden. Die erste Stromquelle IO, I1 liegt zwischen dem inneren Knoten $K_I$, $K_I'$ und einem der beiden Versorgungspotentiale VDD, VSS. Der zweite Transistor Q3, Q4 ist mit seinem Emitter an den inneren Knoten $K_I$, $K_I'$, mit seiner Basis an den Rückkopplungsknoten $K_R$ und mit seinem Kollektor an den Eingang des Stromverstärkers SV1, SV2 angeschlossen. Das Rückkopplungsnetzwerk wird hier durch zwei Ohm'sche Widerstände RC1, RC2 realisiert. Wie noch im einzelnen ausgeführt wird, liegt parallel zu dem Widerstand RC2, der zwischen dem Rückkopplungsknoten $K_R$ und dem Ausgangsknoten $K_A$ geschaltet ist ein Kompensationskondensator CC.

Die Funktionsweise der in Figur 4 gezeigten erfindungsgemäßen Verstärkerausgangsstufe V läßt sich durch folgende Betrachtung erläutern:

Die Eingangsspannung $U_e$ wird ausgehend vom Ruhepunkt, welcher dem Massepotential entspricht, erhöht. Dadurch steigt die Basis-Emitter-Spannung des Transistors Q3 und somit der Kollektorstrom durch diesen Transistor Q3. Dieser steigende Strom wird durch den Stormverstärker SV1 verstärkt und zum Ausgang $K_A$ übertragen, wo er einen Spannungsanstieg an einer ausgangsseitigen Last bewirkt, welche beispielsweise durch die Parallelschaltung eines Lastwiderstandes $R_L$ und eines Lastkondensators $C_L$ gebildet sein kann. Dieser Spannungsanstieg wird durch den Spannungsteiler RC1, RC2 vermindert und der Basis des Transistors Q3 zugeführt, wodurch die Basis-Emitter-Spannung dieses Transistors Q3 vermindert und dadurch der Stromanstieg durch diesen Transistor Q3 begrenzt wird, sobald die Ausgangsspannung das T-fache der Eingangsspannung erreicht hat, wobei gilt:
$$T = (RC1 + RC2) / RC1.$$

Bei dem Transistor Q4 verringert sich die Basis-Emitter-Spannung bei Erhöhung der Eingangsspannung $u_e$, so daß zu dem zu diesem Transistor Q4 gehörenden Stromverstärker SV2 weniger Strom übertragen wird, wodurch sich gleichfalls die Ausgangsspannung erhöht. Da sich durch den Anstieg der Ausgangsspannung die Basis-Emitter-Spannung an diesem Transistor Q4 wieder erhöht, wird der Strom durch diesen Transistor Q4 nicht abrupt abgeschaltet, sondern erst relativ spät und vergleichsweise sanft verlaufend abgeschaltet, wie formelmäßig leicht gezeigt werden kann.

Da die Basis-Emitter-Dioden der hier gezeigten Transistoren Q1, Q2, Q3 und Q4 eine geschlossene Schleife bilden, gilt für deren Basisströme und somit auch für deren Kollektorströme $I_C$, Q1 • $I_C$, Q2 = $I_C$, Q3 • $I_C$, Q4. Das Produkt $I_C$, Q1 • $I_C$, Q2 wird durch die Stromquellen IO, I1 nahezu konstant gehalten, so daß auch das Produkt $I_C$, Q3 • $I_C$, Q4 in erster Näherung konstant ist. Die Abschaltcharakteristik der Transistoren Q3, Q4 der Endstufe ist also derart, daß sich bei Verdoppelung des Stromflusses in der einen Hälfte der Stufe dieser in der anderen Hälfte halbiert. Das unerwünschte völlige Abschalten einer Hälfte der Verstärkerausgangsstufe, wie es in der Erläuterung der Versärker TV1 und TV2 in Fig. 3 gefordert wird, ist also nicht möglich. Somit weist diese Stufe ein ähnliches Verhalten wie die bekannte Klasse-AB-Gegentaktendstufe auf, bei der Übernahmeverzerrungen beim NullDurchgang des Eingangssignales vermieden werden, indem beide Ausgangstransistoren zum Zeitpunkt des Nulldurchganges leitend gehalten werden.

Folgende Überlegungen dokumentieren die Niederohmigkeit des Ausganges $K_A$ der erfindungsgemäßen Verstärkerausgangsstufe V: Es sei angenommen, daß durch eine Ursache unbekannter Art die Ausgangsspannung ansteige. Dies führt über den Spannungsteiler RC1, RC2 zu einem Anstieg an dem Rückkopplungsknoten $K_R$ und damit zu einer Reduktion der Basis-Emitter-Spannung am Transistor Q3 und zu einem Anstieg der Basis-Emitter-Spannung am Transistor Q4. Der Strom durch Q4 steigt an, wird verstärkt zum Ausgang übertragen und bewirkt eine Absenkung der Ausgangsspannung.

Die Kompensation der Stufe erfolgt über die Teilerwiderstände RC1, RC2 und den Kompensationskondensator CC. Bei hochfrequenten Ausgangssignalen schließt der Kondensator CC den Widerstand RC2 kurz, so daß das Ausgangssignal voll in die Basen der Transistoren Q3, Q4 eingekoppelt wird und damit Schwingungen entgegenwirkt.

Die erfindungsgemäße Verstärkerausgangsstufe ist bis hinunter zu einer Versorgungsspannung von 2 V, d. h. +/- 1 V bezogen auf Masse funktionstüchtig. Bei derartigen Versorgungspegeln wird es als bevorzugt angesehen, die Stufe mit einem hohen Teilerfaktor T zu betreiben. Für den Teilerfaktor gilt: T = (RC1 + RC2)/RC1. Der Teilerfaktor T ist identisch mit der Spannungsverstärkung der Ausgangsstufe, die größer als eins ist. Bei derartigen Versorgungspegeln wird ein Teilerfaktor von etwa 10 als bevorzugt angesehen, da der Eingang der Ausgangsstufe schon bei kleinen Spannungshüben von oberhalb 0,2 V übersteuert wird und somit zur Erzielung einer großen Aussteuerung am Ausgang eine große Spannungsverstärkung T einzustellen ist.

Wie in Figur 5 gezeigt ist, kann die Schaltung gemäß Figur 4 auch in MOS-Technik aufgebaut werden. In diesem Fall sind die ersten Transistoren M1, M2 mit ihren Gates mit dem Eingangsknoten $K_E$, mit ihrem Drain mit dem Bezugspotentialknoten und mit ihrer Source mit dem inneren Knoten $K_I$, $K_I'$ verbunden.

Die zweiten Transistoren M3, M4 sind in diesem Fall mit ihrer Source mit dem inneren Knoten $K_I$, $K_I'$, mit ihrem Gate mit dem Rückkopplungsknoten $K_R$ und mit ihrem Drain mit dem Eingang des Stromverstärkers SV1, SV2 verbunden.

Die Funktion der in Figur 5 gezeigten Verstärkerstufe in MOS-Technik ist zwar schlechter als diejenige der in Figur 4 gezeigten Verstärkerstufe in Bipolartechnik, aber dennoch besser als die Funktion vergleichbarer Ausgangsstufen nach dem Stand der Technik. Durch die kleinere Steilheit der MOS-Transistoren M1 bis M4 ist die Spannungsdifferenz zwischen dem Eingangsknoten $K_E$ und dem Ausgangsknoten $K_A$ größer als in der bipolaren Version gemäß Figur 4, da die Gate-Source-Strecken dieser Transistoren M1 bis M4 stärker schwanken als die Basis-Emitter-Strecken in der Bipolarversion. Dadurch sinkt die Spannungsverstärkung der Stufe ab und ist schlechter definiert. Die MOS-Version gemäß Figur 5 eignet sich daher besser für etwas größere Versorgungsspannungen als die Bipolarversion gemäß Figur 4. Die Transistoren M1 bis M5 sollten mit großen W/l-Verhältnissen betrieben werden, also nahe des oder im sogenannten sub-threshold-Bereich. Da die Transistoren dann sehr groß werden, eignet sich die MOS-Version schlecht für die großen Ströme der bipolaren Version, so daß die MOS-Version mit niedrigeren Strömen betrieben werden sollte.

Allgemein reduziert die erfindungsgemäße Struktur der Verstärkerausgangsstufe den Aufwand für den Entwurf einer niederohmigen Ausgangsstufe, erhöht deren Bandbreite und bewirkt, daß deren Ausgangswiderstand im Betriebsfrequenzbereich frequenzunabhängiger wird. Die erfindungsgemäße Verstärkerausgangsstufe eignet sich zum Treiben hoher resistiver und kapazitiver Lasten, ohne daß Stabilitätsprobleme auftreten. Der Eingangswiderstand der erfindungsgemäßen Verstärkerausgangsstufe ist zwar größer als der Eingangswiderstand der Endstufentransistoren der Schaltung gemäß Figur 2 jedoch kleiner als der Eingangswiderstand der Gesamtstufe gemäß Figur 2. Die erfindungsgemäße Verstärkerausgangsstufe kann mit einer Spannungsverstärkung größer 1 implementiert werden. Die Spannungsverstärkung kann durch geeignete Wahl der Rückkopplungswiderstände RC1, RC2 in den Grenzen zwischen 2 und 10 eingestellt werden.

Das in Figur 6 gezeigte Ausführungsbeispiel unterscheidet sich von der Struktur der Verstärkerausgangsstufe nach Figur 4 in dreifacher Hinsicht.

Einerseits sind hier die Stromverstärker SV1, SV2 durch einen dritten bis sechsten Transistor Q5, Q7, Q9, Q11; Q6, Q8, Q10, Q12 gebildet, die als Stromspiegel geschaltet sind.

Der Verstärkungsfaktor der Stromspiegel Q5, Q7, Q9, Q11; Q6, Q8, Q10, Q12 beträgt bei dem gezeigten Ausführungsbeispiel 200. Hier können ohne Einschränkungen anstelle von bipolaren Transistoren Transistoren in MOS-Technik verwendet werden.

In weiterer Abweichung von der Ausführungsform gemäß Figur 4 sind zwei weitere Komponenten in den Stromverstärker integriert worden, nämlich einerseits die zweiten Stromquellen I2, I3 und andererseits die Emitterfolgerschaltungen Q13, R1; Q14, R2.

Durch die zweiten Stromquellen I2, I3, welche ungefähr übereinstimmende Ströme einprägen, wird der überflüssige Strom durch die zweiten Transistoren Q3, Q4 abgeführt. Diese Maßnahme reduziert den Ruhestrom der Ausgangsstufe, der sonst bei großen Stromverstärkungen SV1 und SV2 zu hoch wäre. Durch die Einführung dieser zweiten Stromquellen I2, I3 ist es möglich und erwünscht, bei großen Ausgangsaussteuerungen eine Hälfte der Ausgangsstufe, bezogen auf die Symmetrieachse, vollständig abzuschalten. Dies bedeutet, daß entweder der Transistor Q5 oder der Transistor Q6 abschaltet.

Beim Wiedereinschalten muß erst die Basisspannung dieser Transistoren auf einen Wert von etwa 0,6 bis 0,8 V steigen, was relativ lange dauern kann.

Zu diesem Zweck sind die Emitterfolgerschaltungen Q13, R1; Q14, R2 vorgesehen, die die Absolutwerte der Basis-Emitter-Spannungen der Transistoren Q5 und Q6 nach unten je nach dem Wert der Vorspannungen BIAS 1, BIAS 2 auf 0,5 V bis 0,6 V begrenzen. Ein vollständiges Abschalten einer Stufenhälfte wird auf diese Weise vermieden. Die Transistoren Q13, Q14 können ebenfalls durch MOS-Transistoren ersetzt werden, da es im Fall einer bipolaren Ausführung dieser Transistoren ohnehin erforderlich ist, deren Steilheit durch Emitterwiderstände zu verringern.

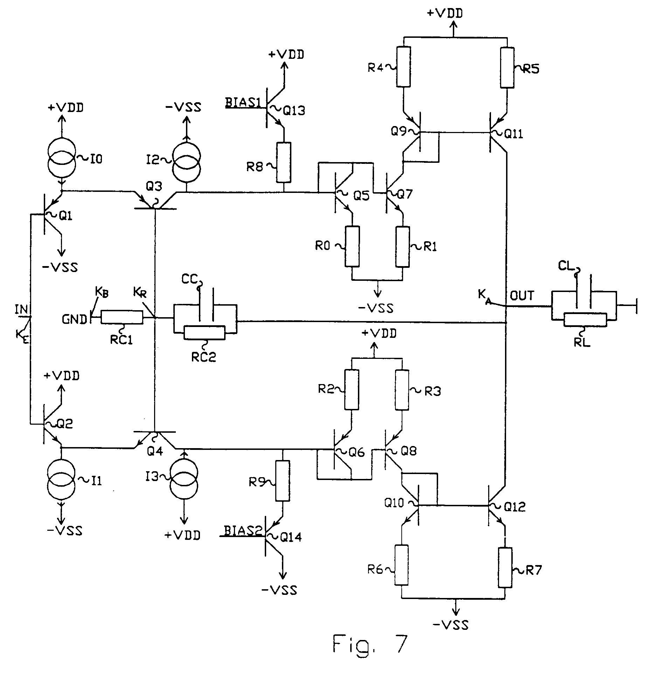

Die in Figur 7 gezeigte weitere Ausführungsform der erfindungsgemäßen Verstärkerausgangsstufe unterscheidet sich von der Ausführungsform nach Figur 6 dadurch, daß hier zur Reduktion des Gesamtruhestromes die logarithmischen Stromspiegel Q5, Q7, R0, R1; Q9, Q11, R4, R5; Q6, Q8, R2, R3; Q10, Q12, R6, R7 eingesetzt werden. Im Vergleich zu der Schaltung nach Figur 6 werden hier jeweils die Emitter der Bipolartransistoren über Widerstände mit den Bezugspotentialen VDD, VSS verbunden. Die symmetrisch angeordneten Widerstände R0, R2; R1, R3; R4, R6; R5, R7 haben jeweils im wesentlichen übereinstimmende Werte. Wenn der Widerstandswert von R0 größer als derjenige von R1 und der Widerstandswert von R4 größer als derjenige von R5 ist, ist der Stromverstärkungsfaktor für kleine Ausgangsströme klein und für große Ausgangsströme groß, so daß der Ruhestrom durch die Transistoren Q3 und Q4 wesentlich weniger verstärkt wird, wodurch eine weitere Abnahme des Ruhestromes erzielt wird. Bei kleinen Strömen bestimmen die Verhältnisse der Emitterflächen der Transistoren das Spiegelverhältnis, während bei großen Strömen die Widerstände das Spiegelverhältnis bestimmen.

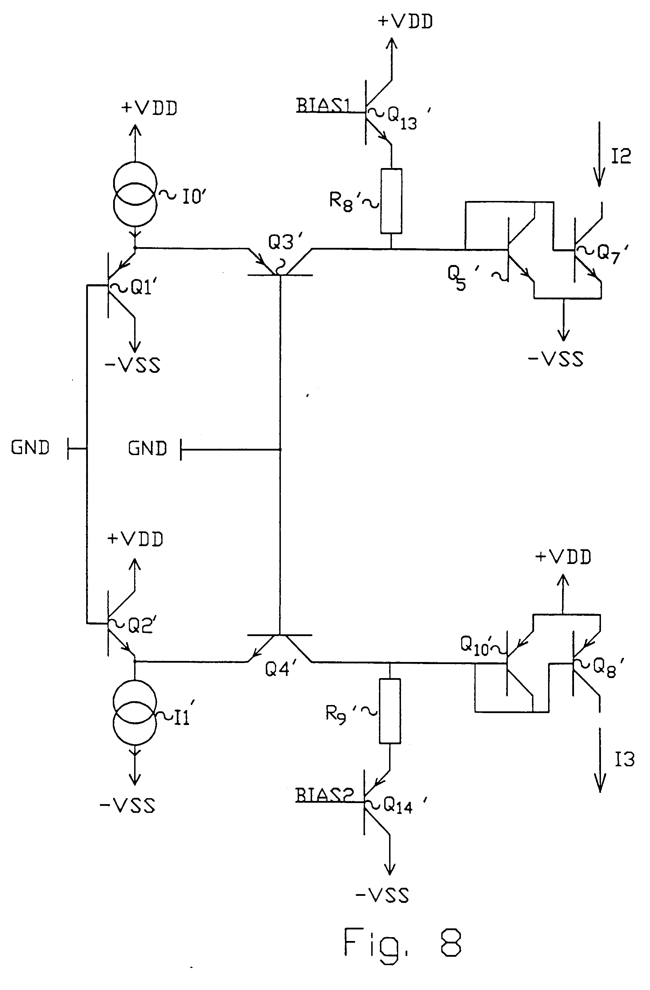

Figur 8 zeigt eine weitere Teil-Ausgangsstufe, die zur Erzeugung der Ströme I2, I3 beispielsweise bei der Ausführungsform der Verstärkerausgangsstufe gemäß Figur 6 dient und mit Ausnahme der dort gezeigten Stromquellen I2, I3 sämtliche Elemente umfaßt, die die Schaltung gemäß Figur 6 zwischen dem Eingangsknoten $K_E$ und den Kollektoren der Transistoren Q7, Q8 aufweist. Die Teil-Ausgangsstufe gemäß Figur 8 ist mit der Ausgangsstufe gemäß Figur 6 gepaart. Übereinstimmende Schaltungselemente sind mit übereinstimmenden Bezugszeichen bezeichnet, die jedoch bei der Teil-Ausgangsstufe gemäße Figur 8 mit einem " ' " versehen sind. Werden durch gepaarte Ausführung der Elemente und durch auslegungsmäßige Maßnahmen die Transistoren Q1, Q1', Q2, Q2', Q3, Q3', Q4, Q4' und die Stromquellen I0, I0' sowie I1, I1' thermisch eng gekoppelt, so kann die Drift des Ruhestromes zum großen Teil kompensiert werden.

Es sei jedoch angemerkt, daß bei der Ruhestromkompensationsschaltung gemäß Figur 8 zur Erzeugung der Ströme I2, I3, diejenigen Knoten auf Bezugspotential bzw. Masse gelegt sind, bei der Verstärkerausgangsstufe V gemäß Figur 6 dem Eingangsknoten $K_E$ und dem Rückkopplungsknoten $K_R$ entsprechen.

**Patentansprüche**

1. Verstärkerausgangsstufe (V) umfassend

   - zwei komplementäre Transkonduktanzverstärker (TV1, TV2) mit jeweils zwei Eingängen und einem Ausgang, die jeweils eine asymmetrische Charakteristik ihres Ausgangsstromes von der an ihren Eingängen anliegenden Spannung bei entgegengesetzten Stromflußrichtungen ihrer Ausgangsströme haben, wobei der Ausgangsstrom des einen Transkonduktanzverstärkers (TV1) mit wachsender positiver Eingangsspannung wächst, bei der Eingangsspannung null einen positiven Wert hat und mit wachsender negativer Eingangsspannung abnimmt, und wobei der Ausgangsstrom des anderen Transkonduktanzverstärkers (TV2) mit wachsender negativer Eingangsspannung wächst, bei der Eingangsspannung null einen negativen Wert hat und mit wachsender positiver Eingangsspannung abnimmt, und

   - zwei Stromverstärker (SV1, SV2), deren Eingänge mit den Ausgängen der Transkonduktanzverstärker (TV1, TV2) verbunden sind und deren Ausgänge mit dem Ausgangsknoten (K$_A$) der Verstärkerausgangsstufe (V) verbunden sind, wobei der Stromverstärker (SV1, SV2) wenigstens eine Stromspiegelschaltung (Q5, Q7, Q9, Q11; Q6, Q8, Q10, Q12) aufweist, und wobei je ein Eingang der Transkonduktanzverstärker (TV1, TV2) mit den Eingangsknoten (K$_E$) der Verstärkerstufe (V) verbunden ist,
**dadurch gekennzeichnet**,

- daß ein Rückkopplungsnetzwerk (RC1, RC2, CC), vorhanden ist, das zwischen dem Ausgangsknoten (KA) und einem Bezugspotentialknoten (KB) geschaltet ist und einen Rückkopplungsknoten (K$_R$) festlegt, wobei der jeweils andere Eingang der Transkonduktanzverstärker (TV1, TV2) mit dem Rükkopplungsknoten (K$_R$) der Verstärkerausgangsstufe (v) verbunden ist,

- daß eine Emitterfolgerschaltung (Q13, R1; Q14, R2), die ausgangsseitig mit dem Eingang der Stromspiegelschaltung (Q5, Q7, Q9, Q11; Q6, Q8, Q10, Q12) verbunden ist, vorhanden ist,

- daß ein erster Pol einer zweiten Stromquelle (I2, I3) mit dem Ausgang der Transkonduktanzverstärker (TV1, TV2) verbunden ist und

- daß die zweite Stromquelle durch eine Schaltungsanordnung (Q1', IO', Q13', R8', Q5', Q7'; Q2', I1', Q4', R9', Q14', Q10', Q8') gebildet ist, deren Struktur derjenigen des Transkonduktanzverstärkers (TV1, TV2), der Emitterfolgerschaltung (Q13, R8; Q14, R) und der Stromspiegelschaltung (Q5, Q7; Q6, Q8) entspricht, wobei die Knoten dieser Schaltungsanordnung, die dem Eingangsknoten (K$_E$) und dem Rückkopplungsknoten (K$_R$) entsprechen, auf Bezugspotential gelegt sind und wobei der Ausgang der Stromspiegelschaltung (Q'5, Q'7 bzw. Q'10, Q'8) dem ersten Pol und ein Versorgungspotentialknoten einem zweiten Pol der zweiten Stromquelle entspricht.

2. Verstärkerausgangsstufe nach Anspruch 1, dadurch gekennzeichnet,

daß jeder der Transkonduktanzverstärker (TV1, TV2) folgende Merkmale aufweist:

- einen ersten Transistor (Q1, Q2), dessen Basis mit dem Eingangsknoten (K$_E$), dessen Kollektor mit einem Versorgungspotentialknoten (K$_B$) und dessen Emitter mit einem inneren Knoten (K$_I$, K$_I$') verbunden ist,

- eine erste Stromquelle( I0, I1), die an den inneren Knoten (K$_I$, K$_I$') angeschlossen ist und

- einen zweiten Transistor (Q3, Q4), dessen Emitter an den inneren Knoten (K$_I$, K$_I$'), dessen Basis an den Rückkopplungsknoten (K$_R$) und dessen Kollektor an den Eingang des stromverstärkers (SV1, SV2) angeschlossen Sind.

3. Verstärkerausgangsstufe nach Anspruch 1, dadurch gekennzeichnet,

daß jeder Transkonduktanzverstärker (TV1, TV2) folgende Merkmale ausweist:

- einen ersten Transistor (M1, M2) dessen Gate mit dem Eingangsknoten (K$_E$), dessen Drain mit einem Versorgungspotentialknoten (K$_B$) und dessen Source mit einem inneren Knoten (K$_I$, K$_I$') verbunden ist,
- eine erste Stromquelle (I0, I1), die an den inneren Knoten (K$_I$, K$_I$') angeschlossen ist, und
- einen zweiten Transistor (M3, M4), dessen Source an den inneren Knoten (K$_I$, K$_I$'), dessen Gate an den Rückkopplungsknoten (K$_R$) und dessen Drain an den Eingang des Stromverstärkers (SV1, SV2) angeschlossen sind.

4. Verstärkerausgangsstufe nach einem der Ansprüche 1 bis 3, dadurch gekennzeichnet,

daß das Rückkopplungsnetzwerk durch einen Ohm'schen Spannungsteiler gebildet ist, dessen Teilerknoten den Rückkopplungsknoten (K$_R$) bildet.

5. Verstärkerausgangsstufe nach Anspruch 4, dadurch gekennzeichnet,

daß zwischen dem Rückkopplungsknoten (K$_R$) und dem Ausgangsknoten (K$_A$) parallel zu einem der Widerstände (RC2) des Spannungsteilers (RC1, RC2) ein Kompensationskondensator (CC) geschaltet ist.

6. Verstärkerausgangsstufe nach Anspruch 4 oder 5, dadurch gekennzeichnet,

daß der Spannungsteiler einen Teilerfaktor (T) festlegt, der größer als 5 ist.

**Claims**

1. Amplifier output stage (V) comprising

   - two complimentary transconductance amplifiers (TV1,TV2) each having two inputs and one output, which each have an asymmetrical characteristic of their output currents related to the voltage present at their inputs given opposite directions of current flow of their output currents, the output current of one transconductance amplifier (TV1) increasing with an increasing positive input voltage, having a positive value when the input voltage is zero and decreasing with an increasing negative input voltage, and the output current of the other transconductance amplifier (TV2) increasing with an increasing negative input voltage, having a negative value when the input voltage is zero and decreasing with an increasing positive input voltage, and
   - two current amplifiers (SV1,SV2), whose inputs are connected to the outputs of the transconductance amplifiers (TV1,TV2), and whose outputs are connected to the output node ($K_A$), of the amplifier output stage (V), the current amplifier (SV1,SV2), having at least one current mirror circuit (Q5,Q7,Q9,Q11;Q6,Q8,Q10,Q12), and a respective input of the transconductance amplifiers (TV1,TV2) being connected to the input nodes ($K_E$) of the amplifier stage (V), characterized
   - in that a feedback network (RC1,RC2,CC) is present, which is connected between the output node (KA) and a reference-earth potential node (KB) and defines a feedback node ($K_R$), the respective other input of the transconductance amplifiers (TV1,TV2) being connected to the feedback node ($K_R$) of the amplifier output stage (V),
   - in that an emitter follower circuit (Q13,R1; Q14,R2) is present, which is connected on the output side to the input of the current mirror circuit (Q5,Q7,Q9,Q11;Q6,Q8,Q10,Q12),
   - in that a first pole of a second current source (12,13) is connected to the output of the transconductance amplifiers (TV1,TV2), and
   - in that the second current source is formed by a circuit arrangement (Q1',I0',Q13',R8',Q5',Q7';Q2',I1',Q4', R9',Q14',Q10',Q8), whose structure corresponds to that of the transconductance amplifier (TV1,TV2), the emitter follower circuit (Q13,R8;Q14,R) and the current mirror circuit (Q5,Q7;Q6,Q8), the nodes of this circuit arrangement which correspond to the input node ($K_E$) and the feedback node ($K_R$) being connected to reference-earth potential, and the output of the current mirror circuit (Q'5,Q'7 and Q'10,Q'8) corresponding to the first pole and a supply potential node corresponding to a second pole of the second current source.

2. Amplifier output stage according to Claim 1, characterized
   in that each of the transconductance amplifiers (TV1,TV2) has the following features:

   - a first transistor (Q1,Q2) whose base is connected to the input node ($K_E$), whose collector is connected to a supply potential node ($K_B$) and whose emitter is connected to an inner node ($K_I$,$K_I'$),
   - a first current source (I0,I1), which is connected to the inner node ($K_I$,$K_I'$), and
   - a second transistor (Q3,Q4), whose emitter is connected to the inner node ($K_I$,$K_I'$), whose base is connected to the feedback node ($K_R$) and whose collector is connected to the input of the current amplifier (SV1,SV2).

3. Amplifier output stage according to Claim 1, characterized

   in that each transconductance amplifier (TV1,TV2) has the following features:

   - a first transistor (M1,M2) whose gate is connected to the input node ($K_E$), whose drain is connected to a supply potential node ($K_B$) and whose source is connected to an inner node ($K_I$,$K_I'$),
   - a first current source (I0,I1), which is connected to the inner node ($K_I$,$K_I'$), and
   - a second transistor (M3,M4), whose source is connected to the inner node ($K_I$,$K_I'$), whose gate is connected to the feedback node ($K_R$) and whose drain is connected to the input of the current amplifier (SV1,SV2).

4. Amplifier output stage according to one of Claims 1 to 3, characterized

   in that the feedback network is formed by a resistive voltage divider whose divider node forms the feedback node ($K_R$).

5. Amplifier output stage according to Claim 4, characterized

   in that, between the feedback node ($K_R$) and the output node ($K_A$) a compensation capacitor (CC) is connected in parallel with one of the resistors (RC2) of the voltage divider (RC1,RC2).

**6.** Amplifier output stage according to Claim 4 or 5, characterized

    in that the voltage divider defines a divider factor (T), which is greater than 5.

**Revendications**

**1.** Etage de sortie amplificateur (V) comprenant

- deux amplificateurs transconducteurs complémentaires (TV1, TV2) comportant chacun deux entrées et une sortie, qui possèdent chacun une caractéristique asymétrique de leur courant de sortie de la tension présente à leurs entrées avec des directions d'écoulement du courant opposées de leur courant de sortie, le courant de sortie de l'un des amplificateurs transconducteurs (TV1) croissant proportionnellement à l'augmentation de la tension d'entrée positive, dans lequel la tension d'entrée zéro a une valeur positive et diminue proportionnellement à l'augmentation de la tension d'entrée négative, et le courant de sortie de l'autre amplifcateur transconducteur (TV2) croissant proportionnellement à l'augmentation de la tension d'entrée négative, dans lequel la tension d'entrée zéro a une valeur négative et diminue proportionnellement à l'augmentation de la tension d'entrée positive, et

- deux amplificateurs de courant (SV1, SV2), dont les entrées sont reliées aux sorties des amplificateurs transconducteurs (TV1, TV2) et dont les sorties sont reliées au noeud de sortie ($K_A$) de l'étage de sortie amplificateur (V), l'amplificateur de courant (SV1, SV2) comportant au moins un circuit miroir de courant (Q5, Q7, Q9, Q11; Q6, Q8, Q10, Q12), et une entrée respectivement des amplicateurs transconducteurs (TV1, TV2) étant reliée au noeud d'entrée ($K_E$) de l'étage amplificateur (V), **caractérisé en ce que**

- un réseau de réaction (RC1, RC2, CC) est présent et hranché entre le noeud de sortie (KA) et un noeud à potentiel de référence (KB) et définit un noeud de réaction ($K_R$), l'autre entrée des amplificateurs transconducteurs (TV1, TV2) étant reliée au noeud de réaction ($K_R$) de l'étage de sortie amplificateur (V),

- en ce qu'un circuit-suiveur séquentiel (Q13, R1; Q14, R2), relié côté sortie à l'entrée du circuit miroir de courant (Q5, Q7, Q9, Q11; Q6, Q8, Q10, Q12), est présent,

- en ce qu'un premier pôle d'une seconde source de courant (12, 13) est relié à la sortie des amplificateurs transconducteurs (TV1, TV2) et

- en ce que la seconde source de courant est formée par un ensemble de circuits (Q1', IO', Q13', R8', Q5', Q7'; Q2', I1', Q4', R9', Q14', Q10', Q8'), dont la structure correspond à celle de l'amplificateur transconducteur (TV1, TV2), du circuit-suiveur séquentiel (Q13, R8; Q14, R), et du circuit miroir de courant (Q5, Q7, Q6, Q8) les noeuds de cet ensemble de circuits qui correspondent aux noeuds d'entrée $K_E$ et aux noeuds de réaction ($K_R$), sont placés sur le potentiel de référence et la sortie du circuit miroir de courant (Q'5, Q'7 resp. Q'10, Q'8) correspondant au premier pôle et à un noeud à potentiel d'alimentation correspondant à un deuxième pôle de la seconde source de courant.

**2.** Etage de sortie amplificateur selon la revendication 1, caractérisé en ce que

    chacun des amplificateurs transducteurs (TV1, TV2) présente les caractéristiques suivantes:

- un premier transistor (Q1, Q2), dont la base est reliée au noeud d'entrée ($K_E$), dont le collecteur est relié à un noeud à potentiel d'alimentation ($K_B$) et dont l'émetteur est relié à un noeud interne ($K_I$, $K_I'$),

- une première source de courant (10, I1) est raccordée au noeud interne ($K_I$, $K_I'$) et

- un second transistor (Q3, Q4), dont l'émetteur est raccordé au noeud interne ($K_I$, $K_I'$) dont la base est raccordée au noeud de réaction ($K_R$) et dont le collecteur est raccordé à l'entrée de l'amplificateur de courant (SV1, SV2).

**3.** Etage de sortie amplificateur selon la revendication 1, caractérisé en ce que

    chaque amplificateur transconducteur (TV1, TV2) présente les caractéristiques suivantes:

- un premier transistor (M1, M2) dont la porte est reliée au noeud d'entrée ($K_E$), dont le drain est relié à un noeud à potentiel d'alimentation ($K_B$) et dont la source est reliée à un noeud intérieur ($K_I$, $K_I'$),

- une première source de courant (10, I1), qui est raccordée au noeud interne ($K_I$, $K_I'$) et

- un second transistor (M3, M4), dont la source est raccordée au noeud interne ($K_I$, $K_I'$), dont la porte est raccordée au noeud de réaction ($K_R$) et dont le drain est raccordé à l'entrée de l'amplificateur de courant (SV1, SV2).

4. Etage de sortie amplificateur selon l'une des revendications 1 à 3, caractérisé en ce que

le réseau de réaction est formé par un diviseur de tension ohmique, dont le noeud diviseur forme le noeud de réaction ($K_R$).

5. Etage de sortie amplificateur selon la revendication 4, caractérisé en ce que

entre le noeud de réaction ($K_R$) et le noeud de sortie ($K_A$) un condensateur de compensation (CC) est branché en parallèle à l'une des résistances (RC2) du diviseur de tension (RC1, RC2).

6. Etage de sortie amplificateur selon la revendication 4 ou 5, caractérisé en ce que

le diviseur de tension définit un facteur de division (T) supérieur à 5.

+VDD

IO~

~ T4

T3~

OUT

T2~

~ T5

T1 ~

IN

-VSS

Fig. 1

Fig. 2

Richtung des Stromflusses

Fig. 3

Fig. 4

Fig. 5

Fig. 6

Fig. 7

Fig. 8